# EUROPEAN PATENT APPLICATION

(11) **EP 1 889 931 A1**
(43) Date of publication of application: **20.02.2008**
(21) Application number: 06766580.2
(22) Date of filing: 12.06.2006
(51) Int. Cl.: C22C 5/06

(54) **SILVER ALLOY HAVING EXCELLENT REFLECTIVITY/TRANSMISSIVITY MAINTAINING CHARACTERISTICS**

(30) Priority: 10.06.2005 JP 2005170871
(71) Applicant: TANAKA KIKINZOKU KOGYO KABUSHIKI KAISHA, Chiyoda-ku, Tokyo 100-6422 (JP)
(72) Inventor: OBATA, Tomokazu, TANAKA KIKINZOKU KOGYO K.K., Isehara-shi, Kanagawa 259-1146 (JP); YANAGIHARA, Hiroshi, TANAKA KIKINZOKU KOGYO K.K, Isehara-shi, Kanagawa 259-1146 (JP)
(74) Representative: Setna, Rohan P.
(86) International application number: PCT/JP2006/311718
(87) International publication number: WO 2006/132415

(57) **Abstract**

The present invention is a silver alloy having excellent reflectance and transmittance, containing silver as a main component and as a first added element group at least one of nickel, molybdenum, copper, cobalt, titanium, scandium, yttrium, manganese, silicon, iron, zirconium, niobium, tantalum, tungsten, chromium and carbon. Here, the first added element group is preferably copper, titanium, zirconium, manganese and yttrium, and further, it is preferable to add at least one of gallium, palladium or dysprosium as a second added element group. Further, the added element concentration total is preferably 0.01 to 20.0 atom%.

## Description

### Technical Field

The present invention relates to a silver alloy suitable as a constituent material of a reflective/transmissive film provided in optical recording media, displays and the like. The present invention especially relates to a silver alloy which can maintain reflectance and transmittance even for long-term use.

### Background Art

Silver is a precious metal which has long been used as a decorative material in accessories, spectacle frames and the like. However, by utilizing its high optical reflectance, silver is also used as a constituent material of reflective films (layers) used in various industrial products.

For example, high-reflectance silver is a preferred material in display devices such as liquid crystal displays and organic EL displays because it effectively utilizes the light from a light source or light-emitting element. Silver is also useful as a coating material to provide a light reflecting function in building materials such as glass, film and sheets. Further possible uses might include applications in lighting systems such as in the reflecting mirror of light fittings or in the reflective surface of a reflector in LED light-emitting devices whose applications have been increasing in recent years.

In addition, silver can also be applied as a transmissive film or semi-transmissive/reflective film because it has excellent optical transparency if its film thickness is appropriately adjusted. For example, in the above-described applications, it is also possible to use silver in transmissive or semi-transmissive display devices, or for the silver to provide a function in glass building materials in which visible light rays are allowed to pass through while UV-rays are reflected.

However, silver has poor environmental resistance and turns black from corrosion, and thus has the problem that reflectance/transmittance deteriorates. Although the exact factors for such corrosion depend on the product being used, in general, moisture in the atmosphere or the like is a factor.

Silver also suffers from the problem that reflectance/transmittance deteriorates from heat as well. While the mechanism for this heat-induced reflectance/transmittance deterioration is not certain, a phenomenon has been confirmed wherein when a silver thin film is heated, localized agglomerates form on the thin film, whereby the underlying layer is exposed. Therefore, heat resistance is also required since the reflective/transmissive film of a display device may be subjected to heating.

Accordingly, development of silver alloys for reflective films which have improved environmental resistance has been carried out in the past in order to solve such problems with the environmental resistance of silver. Most of such development has used silver as a main constituent, to which is added 1 or more kinds of precious metal or the like as an added element.
[Patent Document 1]: Japanese Patent Laid-Open No. 11-134715
[Patent Document 2]: Japanese Patent Laid-Open No. 2000-109943

### Disclosure of the Invention

### Problems to be Solved by the Invention

Some improvement in environmental resistance and heat resistance can be seen in these silver alloys. However, even these silver alloys sometimes deteriorate depending on the usage environment. Therefore, rather than fully guaranteeing that reflectance/transmittance will not deteriorate, there is a need for a material having higher environmental resistance.

Further, especially when thinking of using in a display device, nonuniformity in the level of reflectance/transmittance attenuation from the incident light wavelength should be avoided. This is because if the level of reflectance/transmittance attenuation from the incident light wavelength is non-uniform, anomalies will occur in the color of the light that is reflected/transmitted. Specifically, silver alloys used in a reflective/transmissive film preferably have excellent environmental resistance to various wavelengths and have uniform reflectance/transmittance to light over a broad range of wavelengths (specifically, in the 400 to 800 nm visible light region).

The present invention was made in view of the above-described circumstances. It is an object of the present invention to provide a silver alloy for forming a reflective/transmissive film which is used in display devices, building materials, light fittings and the like, that is a material which can be function without any deterioration in reflectance even for long-term use. It is also an object of the present invention to provide a material which can maintain high reflectance to light over a broad range of wavelengths. In the present invention, the term "environmental resistance" means an ability to suppress deterioration in reflectance and transmittance from the effects of the environment that the silver alloy is placed in, such as a heating atmosphere, a humidifying atmosphere and a sulfidizing atmosphere, and this term may also be referred to as heat resistance, humidity resistance and sulfidation resistance.

### Means for Solving the Problems

In order to solve the above-described problems, the present inventors screened for preferable added elements while having silver as a main component. From those results, the present inventors discovered that the addition of an added element which has a higher melting point than silver, such as nickel, molybdenum, copper, cobalt, titanium, scandium, yttrium, manganese, silicon, iron, zirconium, niobium, tantalum, tungsten, chromium or carbon, is remarkably useful in improving environmental resistance, and is effective in maintaining reflectance/transmittance, thereby arriving at the present invention.

The present invention is a silver alloy having excellent reflectance and transmittance, comprising silver as a main component and as a first added element group at least one of nickel, molybdenum, copper, cobalt, titanium, scandium, yttrium, manganese, silicon, iron, zirconium, niobium, tantalum, tungsten, chromium and carbon.

According to investigations carried out by the present inventors, it was confirmed that a silver alloy to which had been added, among the high melting point elements described for the first added element group, copper, titanium, zirconium, manganese or yttrium, the humidity resistance that is required for a reflective/transmissive film can be kept at a higher level. The humidity resistance of a reflective film can be dramatically improved through the use of these elements individually, or by selecting two, three or even more plural elements and using them in combination as the "first added element group". In addition, each of the elements other than copper, titanium, zirconium, manganese and yttrium in the first added elements is also effective in improving humidity resistance.

In the present invention, it is preferable to further add, as a second added element group, at least one of gallium, thulium, dysprosium, platinum, palladium, magnesium, zinc, terbium, gadolinium, erbium, gold, aluminum, neodymium, holmium, tin, bismuth, praseodymium, germanium, indium, samarium, ytterbium, strontium, boron, rhodium, iridium, ruthenium, zinc, antimony, hafnium, lanthanum, cerium, europium, calcium, lithium and phosphorus. These elements act to improve environmental resistance in a compound manner in conjunction with the first added element group.

Especially, a silver alloy to which gallium, palladium, dysprosium, indium, tin, zinc, magnesium, aluminum, gadolinium, erbium, praseodymium, samarium or lanthanum is added as the second added element group is preferred since such alloy can effectively suppress the agglomeration phenomenon which occurs in the thin film material during a heating environment.

The components comprising the second added element group are mainly added for the purpose of improving especially the heat resistance of the alloy. Specifically, in order to ensure the heat resistance required for a thin film, these elements may be added individually, or by selecting two elements, three elements or even more plural elements.

The added element concentration, or specifically, the total of the concentration of the first added element group and the concentration of the second added element group, is preferably 0.01 to 20.0 atom%. This is because if the added amount is less than 0.01 atom%, there are no effects on improving environmental resistance, while if the added element concentration is more than 20.0 atom%, the reflectance/transmittance of the silver alloy itself deteriorate. In actual practice, there are many different kinds of products which use the thin film comprising the silver alloy according to the present invention, and the required property specifications also vary. Concerning this point, although the present invention, basically, has high reflectance and transmittance, there are many products which require comprising a thin film having environmental resistance performance as its greatest priority. In such a case, the maximum value for the added element concentration is 20.0 atom%. On the other hand, in the case of improving reflectance and transmittance while also emphasizing environmental resistance performance, the added element concentration is 10.0 atom% or less. Further, in the case of giving priority to reflectance and transmittance, the added element concentration is 5.0 atom% or less. Thus, the kind of added element and the added element amount can be adjusted taking into consideration the required property specification for each product in which the thin film is applied.

As described above, the silver alloy as a reflective film material according to the present invention can be produced by melt casting method or sintering. For production by melt casting, there are no especially difficult points, so that production is possible by a common method in which each of the raw materials is weighed out and mixed by melting them together for casting. Further, for production by sintering there are also no especially difficult points, so that production is possible by a common method in which each of the raw materials is weighed out for sintering.

The silver alloy according to the present invention is suitable for applications in display devices such as liquid crystal displays and organic EL displays which use reflective films, transmissive films and semi-transmissive reflective films. When used in such applications, the optimal value for the film thickness may be selected according to the use application. Generally, for a reflective film, this is preferably 1,000 to 1,200 Å. In the case of a transmissive film, this is preferably in the range of 40 to 500 Å depending on the transmittance of the substrate. Further, especially in the case of aiming for high transmittance, this is 50 to 120 Å.

The silver alloy according to the present invention is also suitable as a reflective/transmissive film for glass, films, building materials and the like. In this case, glass, films, building materials and the like having high reflectance or transmittance can be obtained by vapor-depositing or joining the silver alloy according to the present invention to a suitable support surface. Examples of the support include various compositions of glass plate, various kinds of plastic film, plastic board, ceramic plate, metal sheet and the like, and include supports which are appearing as so-called new materials.

Further, sputtering can be utilized to form a thin film comprising the silver alloy according to the present invention for the above-described applications. Accordingly, a sputtering target comprising the silver alloy according to the present invention can produce display devices, such as liquid crystal displays and organic EL displays, glass, films, building materials and the like which comprise a silver film having preferable properties.

### Advantageous Effect of the Invention

As described above, the silver alloy according to the present invention is vastly superior in environmental resistance over a broad range of wavelengths, whereby a reflective/transmissive/semi-transmissive film can be produced having little deterioration in reflectance/transmittance even for long-term use, which allows the life span of a display device, building material or the like comprising a reflective film, transmissive film or the like to be prolonged.

### Best Mode for Carrying Out the Invention

A preferred embodiment of the present invention is described together with comparative examples. Here, silver alloys having various compositions consisting of binary to quinary systems with silver as the main component were produced. From these alloys, targets were produced and thin films were formed by sputtering. These thin films were subjected to corrosion tests (accelerated tests) under various environments, and the change in properties after the corrosion tests was examined. It is noted that the silver alloy according to the present invention is not limited to the binary to quinary systems which the present embodiment is directed to. The silver alloy may also be produced in higher polynary systems. Depending on the product specification, senary or higher polynary alloys can also be produced. Further, the production of such systems involves no particular problems, meaning that mass production is possible.

Production of the silver alloy was conducted by weighing out the individual metals to predetermined concentrations, and mixing the metals by melting them in a high frequency melting furnace to form an alloy. The alloy was cast into a casting mold, which then solidified to form an ingot. The ingot was forged, rolled, heat treated and then shaped into a sputtering target. In addition, the target can also be produced by powder sintering.

Production of the thin films was conducted by placing a slide glass substrate (borosilicate glass) and the target in a sputtering apparatus, evacuating the interior of the apparatus to a vacuum of 5.0×10⁻³ Pa, and then introducing argon gas into the apparatus to give a pressure of 5.0×10⁻¹ Pa. The sputtering conditions were such that a film having a thickness of 1,200 Å was formed by sputtering with a direct current power of 4 kW for 8 seconds and a film having a thickness of 120 Å was formed by sputtering with a direct current power of 0.4 kW for 8 seconds. The film thickness distribution was within ±10%.

Evaluation and examination of the properties of the produced thin films was carried out by conducting corrosion tests which exposed the thin films to a variety of environments, and evaluating the properties of the thin films before and after the testing. In the present embodiment, the produced various silver alloy thin films underwent tests for the compositions which emphasized environmental resistance performance and tests of the compositions which emphasized reflectance/transmittance.

### A: Compositions Emphasizing Environmental Resistance Performance

The tests for compositions emphasizing environmental resistance performance were conducted with a salt water drop test and an adhesion test. Concerning the practicality of a product comprising a silver alloy thin film, ensuring durability in an environment inhabited by humans is given priority. Specifically, it is necessary for a product having a silver alloy thin film to be maintained without deterioration in performance even if corrosion factors exist, such as if people directly touch the product with their hand or if matter such as food or drink adhere to the product. The salt water drop test and adhesion test carried out in the present embodiment are intended to take such a usage environment into consideration.

The salt water drop test is intended to accelerate testing of deterioration by assuming the adhesion of human sweat or seasonings such as soy sauce or soybean paste. A solution of 10.0% aqueous NaCl (25°C) was prepared, and 2 to 3 drops of the solution were dropped onto a 120 Å silver alloy thin film immediately which had just been formed on a slide glass. Changes were observed in order to determine durability performance. Evaluation was determined according to the following 0 to 5 point scale.
"5": Best; no peeling
"4": Good; some peeling
"3": Normal; half peeling
"1": Poor; some remaining
"0": Worst; overall peeling

Films given an evaluation of "3" or higher in the above-described salt water drop test were further subjected to a test to evaluate the adhesion of the thin film to the substrate. The adhesion test was carried out for 3 kinds of samples after exposure to the following environment using thin film samples (thickness of 120 Å) on slide glass having various compositions.
(1) Sample immediately after film formation
(2) Sample that had been subjected to a heating test by, after film formation, heating at 250°C for 1 hour in air on a hot plate
(3) Sample that had been subjected to a humidification test by, after film formation, exposing for 24 hours to an atmosphere having a temperature of 100°C and humidity of 100%

Each sample was cross cut with 11 indented lines at 1 mm intervals by a cutter knife using the dedicated jig of a metal mask to form a grid having a hundred of 1 mm squares (10×10). Then, commercially available cellophane tape was stuck over the cross cut portion, and made to adhere thereto by firmly pressing down. The cellophane tape was then peeled in a perpendicular direction away from the surface in a single spell. Once the tape had been peeled away, the number of remaining squares was counted for evaluation according to a 5 point scale.
"5": Best; no peeling
"4": Good; some peeling
"3": Normal; half peeling
"1": Poor; some remaining
"0": Worst; overall peeling

The evaluation results for the above salt water drop test and adhesion test are shown in Table 1. For comparison, the test results for a pure silver thin film are also shown in the tables.

**[Table 1a]**

| | Sample Composition | Drop Test Drop Test | Adhesion Test | | |
|---|---|---|---|---|---|
| | | | Immediately After Film Formation | After Heating Test | After Humidification Test |
| 1 | Ag-15.0Cu | 5 | 5 | 5 | 5 |
| 2 | Ag-19.0Ti | 5 | 5 | 5 | 5 |
| 3 | Ag-19.0Zr | 5 | 5 | 5 | 5 |
| 4 | Ag-16.0Mn | 5 | 5 | 4 | 3 |
| 5 | Ag-17.0Co | 5 | 5 | 5 | 5 |
| 6 | Ag-15.0Ta | 5 | 5 | 5 | 5 |
| 7 | Ag-2.0Cu-5.0Pd | 5 | 5 | 4 | 5 |
| 8 | Ag-3.0Cu-4.0Pd | 5 | 5 | 5 | 5 |
| 9 | Ag-2.8Cu-4.5Au | 5 | 5 | 5 | 5 |
| 10 | Ag-1.7Cu-1.2Ga | 5 | 5 | 5 | 5 |
| 11 | Ag-3.0Cu-3.0Ga | 5 | 5 | 5 | 5 |
| 12 | Ag-10.0Cu-4.0Ga | 5 | 5 | 5 | 5 |
| 13 | Ag-5.0Cu-5.0Sn | 5 | 5 | 3 | 4 |
| 14 | Ag-3.1Cu-6.6Zn | 5 | 4 | 4 | 4 |
| 15 | Ag-14.5Cu-5.0Al | 4 | 5 | 5 | 5 |
| 16 | Ag-2.2Cu-6.9Mg | 5 | 5 | 5 | 4 |
| 17 | Ag-3.0Cu-2.8Zr | 3 | 5 | 4 | 5 |
| 18 | Ag-5.2Cu-3.1Ti | 5 | 5 | 5 | 5 |
| 19 | Ag-8.7Cu-2.8Mn | 5 | 4 | 3 | 4 |
| 20 | Ag-3.0Cu-2.0Er | 5 | 5 | 4 | 5 |
| 21 | Ag-3.0Cu-2.0Gd | 5 | 5 | 4 | 5 |
| 22 | Ag-5.0Cu-1.5Dy | 5 | 5 | 5 | 5 |
| 23 | Ag-3.5Cu-1.4Er | 5 | 5 | 5 | 5 |
| 24 | Ag-5.3Cu-1.2Sm | 4 | 5 | 4 | 4 |
| 25 | Ag-5.1 Cu-2.5La | 4 | 5 | 5 | 5 |
| 26 | Ag-3.5Cu-1.6Pr | 5 | 5 | 5 | 5 |
| 27 | Ag-3.0Cu-2.0Y | 5 | 5 | 4 | 5 |
| 28 | Ag-3.5Ti-12.5Pd | 5 | 5 | 5 | 5 |
| 29 | Ag-1.5Ti-3.5Sn | 4 | 5 | 4 | 5 |
| 30 | Ag-3.5Ti-1.4Er | 5 | 5 | 5 | 5 |
| 31 | Ag-2.5Ti-2.0Gd | 5 | 5 | 5 | 5 |
| 32 | Ag-2.9Ti-1.5Dy | 4 | 5 | 5 | 5 |
| 33 | Ag-2.5Ti-1.5Sm | 3 | 5 | 4 | 5 |
| 34 | Ag-2.5Ti-6.0Ga | 5 | 5 | 5 | 5 |
| 35 | Ag-2.5Ti-3.0Zr | 4 | 5 | 5 | 5 |
| 36 | Ag-3.0Zr-6.0Ga | 5 | 5 | 5 | 5 |
| 37 | Ag-3.3Zr-2.4Mn | 4 | 5 | 3 | 4 |
| 38 | Ag-2.6Mn-2.5Ga | 5 | 5 | 4 | 5 |
| 39 | Ag-2.0Cu-2.0Ga-6.0Al | 5 | 5 | 5 | 5 |
| 40 | Ag-1.7Cu-1.2Ga-7.0Mg | 5 | 5 | 5 | 5 |
| 41 | Ag-2.0Cu-1.8Ga-6.2Zn | 5 | 5 | 5 | 5 |
| 42 | Ag-0.15Cu-0.15Ga-4.7Pd | 4 | 5 | 4 | 5 |
| 43 | Ag-0.8Cu-1.0Ga-4.4Pd | 5 | 5 | 5 | 5 |
| 44 | Ag-1.0Cu-0.8Ga-5.0Pd | 5 | 5 | 5 | 5 |
| 45 | Ag-2.0Cu-2.0Ga-1.0Pr | 5 | 5 | 5 | 5 |
| 46 | Ag-2.0Cu-1.5Ga-1.3Er | 4 | 5 | 4 | 5 |
| 47 | Ag-5.0Cu-2.8Zr-1.0Er | 5 | 5 | 4 | 4 |
| 48 | Ag-1.7Cu-1.5Ga-1.5Dy | 4 | 5 | 5 | 5 |
| 49 | Ag-10.0Cu-2.0Mn-1.3Dy | 5 | 5 | 5 | 4 |
| 50 | Ag-1.5Cu-2.0Zr-1.5Y | 4 | 5 | 5 | 5 |
| 51 | Ag-9.0Cu-4.3Ga-1.0Y | 5 | 5 | 4 | 5 |
| 52 | Ag-2.0Cu-2.0Ga-0.8Gd | 5 | 5 | 5 | 5 |
| 53 | Ag-1.9Cu-2.5Ga-0.7La | 5 | 5 | 5 | 4 |
| 54 | Ag-1.8Cu-2.0Mn-1.0Sm | 4 | 5 | 5 | 4 |
| 55 | Ag-7.0Cu-1.7Ga-1.2Sm | 5 | 5 | 4 | 5 |
| 56 | Ag-4.7Cu-2.0Ga-1.0In-1.0Sn | 5 | 5 | 4 | 5 |
| 57 | Ag-5.0Cu-2.0Ga-0.8in-1.0Zn | 5 | 5 | 5 | 5 |
| 58 | Ag-1.5Cu-1.6Ti-2.2Mn-1.8Zr | 5 | 5 | 5 | 5 |
| 59 | Ag-8.OCu-2.5Ti-1.7Mn-4.2Zr | 5 | 5 | 5 | 5 |
| 60 | Ag-8.6Cu-3.2Mg-1.6Ga-0.8Zr | 5 | 5 | 5 | 5 |
| | Ag | 0 | 3 | 0 | 0 |

**[Table 1b]**

| | Sample Composition | Salt Water Drop Test | Adhesion Test | | |
|---|---|---|---|---|---|
| | | | Immediately After Film Formation | After Heating Test | After Humidification Test |
| 61 | Ag-1.7Cu-0.6Pt-0.1Li | 5 | 5 | 4 | 5 |
| 62 | Ag-1.7Cu-0.6Pt-0.1P | 5 | 5 | 5 | 4 |
| 63 | Ag-1.7Cu-0.5Pd-0.1Li | 5 | 5 | 5 | 5 |
| 64 | Ag-1.7Cu-0.5Pd-0.1P | 4 | 5 | 5 | 5 |
| 65 | Ag-1.7Cu-0.5Pd-0.1C | 5 | 5 | 5 | 5 |
| 66 | Ag-1.7Cu-0.1B-0.5Pd-0.1Ca | 5 | 5 | 5 | 5 |
| 67 | Ag-1.7Cu-0.5Pd-0.1Mg-0.1Ca | 5 | 5 | 5 | 4 |
| 68 | Ag-1.7Cu-0.5Au-0.1Ca | 5 | 5 | 4 | 5 |
| 69 | Ag-1.7Cu-0.5Au-0.1Mg | 5 | 5 | 5 | 4 |
| 70 | Ag-1.7Cu-0.6Pt | 5 | 5 | 5 | 5 |
| 71 | Ag-0.5Cu-0.6Pt | 5 | 5 | 5 | 5 |
| 72 | Ag-0.5Cu-0.5Pd | 5 | 5 | 5 | 4 |
| 73 | Ag-1.7Cu-1.0Pd | 5 | 5 | 5 | 5 |
| 74 | Ag-2.2Ti-0.5Pd | 5 | 5 | 4 | 5 |
| 75 | Ag-1.2Zr-0.5Pd | 5 | 5 | 5 | 4 |
| 76 | Ag-2.0Mn-0.5Pd | 4 | 5 | 4 | 5 |
| 77 | Ag-0.4Cu-0.5Pd-0.6Ga | 4 | 5 | 3 | 4 |
| 78 | Ag-0.2Cu-0.5Pd-0.5In | 4 | 4 | 4 | 5 |
| 79 | Ag-0.2Cu-0.5Pd-0.5Sn | 5 | 5 | 4 | 4 |
| 80 | Ag-0.2Cu-0.5Pd-0.8Zn | 5 | 5 | 5 | 5 |
| 81 | Ag-0.1Cu-0.5Pd-0.5Mg | 5 | 5 | 5 | 5 |
| 82 | Ag-0.1Cu-0.5Pd-0.5Al | 5 | 5 | 5 | 5 |
| 83 | Ag-0.1Cu-0.5Pd-0.1Bi | 5 | 5 | 5 | 5 |
| 84 | Ag-0.3Cu-0.5Pd-2.2Ti | 5 | 5 | 4 | 5 |
| 85 | Ag-0.3Cu-0.5Pd-1.2Zr | 5 | 5 | 5 | 5 |
| 86 | Ag-0.5Cu-0.5Pd-2.0Mn | 4 | 5 | 4 | 5 |
| 87 | Ag-0.2Cu-0.5Pd-0.3Dy | 5 | 5 | 5 | 5 |
| 88 | Ag-0.2Cu-0.5Pd-0.3Gd | 5 | 5 | 5 | 5 |
| 89 | Ag-0.2Cu-0.5Pd-0.3Er | 5 | 5 | 5 | 5 |
| 90 | Ag-0.1Cu-0.5Pd-0.4Pr | 5 | 5 | 5 | 5 |
| 91 | Ag-0.2Cu-0.5Pd-0.3Sm | 5 | 5 | 4 | 5 |
| 92 | Ag-0.1Cu-0.5Pd-0.4La | 4 | 5 | 5 | 4 |
| 93 | Ag-0.2Cu-0.5Pd-0.3Y | 5 | 5 | 5 | 5 |
| 94 | Ag-0.2Cu-0.5Pd-0.3Nd | 5 | 5 | 5 | 5 |
| 95 | Ag-0.2Cu-0.5Pd-0.3Yb | 5 | 5 | 5 | 5 |
| 96 | Ag-0.2Cu-0.5Pd-0.3Tb | 5 | 5 | 5 | 5 |
| 97 | Ag-0.1 Cu-0.5Pd-0.4Ce | 5 | 5 | 5 | 5 |
| 98 | Ag-0.2Cu-0.5Pd-0.3Ho | 5 | 5 | 5 | 5 |
| 99 | Ag-0.2Cu-0.5Pd-0.3Sc | 5 | 5 | 5 | 5 |
| 100 | Ag-0.2Cu-0.5Pd-0.3Eu | 5 | 5 | 5 | 5 |
| 101 | Ag-0.2Cu-0.5Pd-0.3Tm | 5 | 5 | 5 | 5 |
| 102 | Ag-0.1Cu-0.5Pd-0.3Dy-0.2Ga | 4 | 5 | 4 | 5 |
| 103 | Ag-0.1Cu-0.5Pd-0.3Gd-0.2Ga | 5 | 5 | 5 | 5 |
| 104 | Ag-0.1Cu-0.5Pd-0.3Er-0.2Ga | 4 | 5 | 5 | 5 |
| 105 | Ag-0.1Cu-0.5Pd-0.4Pr-0.2Ga | 5 | 5 | 5 | 5 |
| 106 | Ag-0.1Cu-0.5Pd-0.3Sm-0.2Ga | 5 | 5 | 4 | 4 |
| 107 | Ag-0.1Cu-0.5Pd-0.4La-0.2Ga | 5 | 5 | 5 | 5 |
| 108 | Ag-0.1Cu-0.5Pd-0.3Y-0.2Ga | 5 | 5 | 5 | 5 |
| 109 | Ag-0.1Cu-0.5Pd-0.2Dy-0.2Sm | 5 | 5 | 5 | 4 |
| 110 | Ag-0.1 Cu-0.5Pd-0.2Gd-0.2Dy | 5 | 5 | 5 | 5 |
| 111 | Ag-0.1Cu-0.5Pd-0.2Er-0.2La | 5 | 5 | 5 | 5 |
| 112 | Ag-0.1Cu-0.5Pd-0.2Pr-0.2Er | 5 | 5 | 5 | 5 |
| 113 | Ag-0. 1Cu-0.5Pd-0.2Sm-0.2Er | 5 | 5 | 5 | 5 |
| 114 | Ag-0.1Cu-0.5Pd-0.2La-0.2Pr | 5 | 5 | 4 | 5 |
| 115 | Ag-0.1Cu-0.5Pd-0.2Y-0.2Er | 5 | 5 | 5 | 4 |
| 116 | Ag-0.1Cu-0.5Pd-0.2Nd-0.2Er | 5 | 5 | 5 | 5 |
| 117 | Ag-0.1Cu-0.5Pd-0.2Yb-0.2Er | 5 | 5 | 5 | 5 |
| 118 | Ag-0.1Cu-0.5Pd-0.2Tb-0.2Er | 5 | 5 | 5 | 5 |
| 119 | Ag-0.1Cu-0.5Pd-0.2Ce-0.2Er | 5 | 5 | 5 | 5 |
| 120 | Ag-0.1Cu-0.5Pd-0.2Ho-0.2Pr | 5 | 5 | 5 | 4 |
| | Ag | 0 | 3 | 0 | 0 |

**[Table 1c]**

| | Sample Composition | Salt Water Drop Test | Adhesion Test | | |
|---|---|---|---|---|---|
| | | | Immediately After Film Formation | After Heating Test | After Humidification Test |
| 121 | Ag-0.1Cu-0.5Pd-0.2Sc-0.2Pr | 4 | 5 | 4 | 5 |
| 122 | Ag-0.1Cu-0.5Pd-0.2Eu-0.2Pr | 4 | 5 | 5 | 4 |
| 123 | Ag-0.1Cu-0.5Pd-0.2Tm-0.2Pr | 4 | 5 | 5 | 4 |
| 124 | Ag-0.1 Ti-1.OLi-0.1 Ca | 4 | 5 | 4 | 5 |
| 125 | Ag-0.1 Zr-0.1 C-1.0Li | 4 | 5 | 5 | 4 |
| 126 | Ag-0.1 Zr-1.0P-0.1Ca | 5 | 5 | 4 | 4 |
| 127 | Ag-0.1Mn-0.1B-1.0P | 4 | 5 | 5 | 4 |
| 128 | Ag-1.7Cu-0.1Ti-1.0Ga | 5 | 5 | 5 | 5 |
| 129 | Ag-1.7Cu-0.1Zr-1.0Ga | 5 | 5 | 5 | 5 |
| 130 | Ag-1.7Cu-0.1Mn-1.0Ga | 5 | 5 | 5 | 5 |
| 131 | Ag-1.7Cu-1.0Ga-0.1Mg | 5 | 5 | 5 | 5 |
| 132 | Ag-1.7Cu-1.0Ga-0.1Al | 5 | 5 | 5 | 5 |
| 133 | Ag-1.7Cu-1.0Ga-0.1ln | 5 | 5 | 5 | 5 |
| 134 | Ag-1.7Cu-1.0Ga-0.1Sn | 5 | 5 | 5 | 5 |
| 135 | Ag-1.7Cu-1.0Ga-0.1Zn | 5 | 5 | 5 | 5 |
| 136 | Ag-1.7Cu-0.1Ti-1.0Ga-0.1Mg | 5 | 5 | 5 | 5 |
| 137 | Ag-1.7Cu-0.1 Zr-1.0Ga-0.1 Mg | 5 | 5 | 5 | 5 |
| 138 | Ag-1.7Cu-0.1Mn-1.0Ga-0.1Mg | 5 | 5 | 5 | 5 |
| 139 | Ag-1.7Cu-1.0Ga-0.1Mg-0.1AI | 5 | 5 | 5 | 5 |
| 140 | Ag-1.7Cu-0.1Ti-1.0Ga-0.1Al | 5 | 5 | 5 | 5 |
| 141 | Ag-1.7Cu-0.1Ti-1.0Ga-0.1In | 5 | 5 | 5 | 5 |
| 142 | Ag-1.7Cu-0.1Ti-1.0Ga-0.1Sn | 5 | 5 | 5 | 5 |
| 143 | Ag-1.7Cu-0.1Ti-1.0Ga-0.1Zn | 5 | 5 | 5 | 5 |
| 144 | Ag-1.7Cu-1.0Ga-0.1Dy | 5 | 5 | 5 | 5 |
| 145 | Ag-1.7Cu-1.0Ga-0.1Gd | 5 | 5 | 5 | 5 |
| 146 | Ag-1.7Cu-1.0Ga-0.1Er | 5 | 5 | 5 | 5 |
| 147 | Ag-1.7Cu-1.0Ga-0.1Pr | 5 | 5 | 5 | 5 |
| 148 | Ag-1.7Cu-1.0Ga-0.1La | 5 | 5 | 5 | 5 |
| 149 | Ag-1.7Cu-1.0Ga-0.1Y | 5 | 5 | 4 | 5 |
| 150 | Ag-1.7Cu-1.0Ga-0.1Sm | 5 | 5 | 5 | 4 |
| 151 | Ag-1.7Cu-1.0Ga-0.1Nd | 5 | 5 | 5 | 4 |
| 152 | Ag-1.7Cu-1.0Ga-0.1Yb | 5 | 5 | 5 | 5 |
| 153 | Ag-1.7Cu-1.0Ga-0.1Tb | 5 | 5 | 4 | 5 |
| 154 | Ag-1.7Cu-1.0Ga-0.1Ce | 5 | 5 | 5 | 5 |
| 155 | Ag-1.7Cu-1.0Ga-0.1Ho | 5 | 5 | 4 | 4 |
| 156 | Ag-1.7Cu-1.0Ga-0.1Sc | 4 | 5 | 5 | 4 |
| 157 | Ag-1.7Cu-1.0Ga-0.1Eu | 4 | 5 | 5 | 4 |
| 158 | Ag-1.7Cu-1.0Ga-0.1Tm | 4 | 5 | 4 | 5 |
| 159 | Ag-1.7Cu-1.0Ga-0.1Dy-0.1Pd | 5 | 5 | 5 | 5 |
| 160 | Ag-1.7Cu-1.0Ga-0.1Gd-0.1Pd | 5 | 5 | 5 | 5 |
| 161 | Ag-1.7Cu-1.0Ga-0.1Er-0.1Pd | 5 | 5 | 5 | 5 |
| 162 | Ag-1.7Cu-1.0Ga-0.1Pr-0.1Pd | 5 | 5 | 5 | 5 |
| 163 | Ag-1.7Cu-1.0Ga-0.1La-0.1Pd | 5 | 5 | 5 | 5 |
| 164 | Ag-1.7Cu-1.0Ga-0.1Y-0.1Pd | 4 | 5 | 4 | 4 |
| 165 | Ag-1.7Cu-1.0Ga-0.1Sm-0.1Pd | 4 | 5 | 5 | 4 |
| 166 | Ag-1.7Cu-1.0Ga-0.1Gd-0.1Er | 5 | 5 | 5 | 5 |
| 167 | Ag-1.7Cu-1.0Ga-0.1Gd-0.1Pr | 5 | 5 | 5 | 5 |
| 168 | Ag-1.7Cu-1.0Ga-0.1Er-0.1Pr | 5 | 5 | 5 | 5 |
| 169 | Ag-1.7Cu-1.0Ga-0.1Gd-0.1Dy | 4 | 5 | 5 | 5 |
| 170 | Ag-1.7Cu-1.0Ga-0.1Gd-0.1Sm | 5 | 5 | 5 | 4 |
| 171 | Ag-1.7Cu-1.0Ga-0.1Gd-0.1La | 5 | 5 | 5 | 5 |
| 172 | Ag-1.7Cu-1.0Ga-0.1Gd-0.1Y | 5 | 5 | 4 | 5 |
| 173 | Ag-1.7Cu-1.0Ga-0.1Er-0.1Dy | 5 | 5 | 5 | 5 |
| 174 | Ag-1.7Cu-1.0Ga-0.1Er-0.1Sm | 4 | 5 | 5 | 5 |
| 175 | Ag-1.7Cu-1.0Ga-0.1Er-0.1La | 5 | 5 | 5 | 5 |
| 176 | Ag-1.7Cu-1.0Ga-0.1Er-0.1Y | 5 | 5 | 5 | 4 |
| 177 | Ag-1.7Cu-1.0Ga-0.1 Pr-0.1 Dy | 5 | 5 | 5 | 5 |
| 178 | Ag-1.7Cu-1.0Ga-0.1Pr-0.1Sm | 5 | 5 | 4 | 5 |
| 179 | Ag-1.7Cu-1.0Ga-0.1 Pr-0.1La | 5 | 5 | 5 | 5 |
| 180 | Ag-1.7Cu-1.0Ga-0.1 Pr-0.1Y | 5 | 5 | 5 | 4 |
| | Ag | 0 | 3 | 0 | 0 |

**[Table 1d]**

| | Sample Composition | Salt Water Drop Test | Adhesion Test | | |
|---|---|---|---|---|---|
| | | | Immediately After Film Formation | After Heating Test | After Humidification Test |
| 181 | Ag-1.7Cu-1.2Ga-0.1Er-0.1Nd | 5 | 5 | 4 | 5 |
| 182 | Ag-1.7Cu-1.2Ga-0.1Er-0.1Yb | 5 | 5 | 5 | 5 |
| 183 | Ag-1.7Cu-1.2Ga-0.1Er-0.1Tb | 5 | 5 | 4 | 4 |
| 184 | Ag-1.7Cu-1.2Ga-0.1Er-0.1Ce | 5 | 5 | 5 | 5 |
| 185 | Ag-1.7Cu-1.2Ga-0.1Er-0.1Ho | 5 | 5 | 5 | 4 |
| 186 | Ag-1.7Cu-1.2Ga-0.1Pr-0.1Nd | 5 | 5 | 4 | 5 |
| 187 | Ag-1.7Cu-1.2Ga-0.1Pr-0.1Yb | 5 | 5 | 5 | 5 |
| 188 | Ag-1.7Cu-1.2Ga-0.1Pr-0.1Tb | 5 | 5 | 5 | 4 |
| 189 | Ag-1.7Cu-1.2Ga-0.1Pr-0.1ce | 5 | 5 | 5 | 5 |
| 190 | Ag-1.7Cu-1.2Ga-0.1Pr-0.1Ho | 5 | 5 | 5 | 4 |
| 191 | Ag-1.7Cu-0.3Nd | 4 | 5 | 5 | 4 |
| 192 | Ag-1.7Cu-0.3Yb | 5 | 5 | 5 | 5 |
| 193 | Ag-1.7Cu-0.3Tb | 4 | 5 | 4 | 5 |
| 194 | Ag-1.7Cu-0.4Ce | 5 | 5 | 5 | 5 |
| 195 | Ag-1.7Cu-0.3Ho | 4 | 5 | 4 | 5 |
| 196 | Ag-1.7Cu-0.3Eu | 3 | 5 | 4 | 4 |
| 197 | Ag-1.7Cu-0.3Dy-0.1Li | 5 | 5 | 5 | 5 |
| 198 | Ag-1.7Cu-0.4Pr-0.1P | 5 | 5 | 5 | 5 |
| 199 | Ag-1.7Cu-0.1C-0.4La | 5 | 5 | 5 | 5 |
| 200 | Ag-1.7Cu-0.1B-0.3Y-0.1Ca | 3 | 5 | 4 | 4 |
| 201 | Ag-1.7Cu-0.3Gd-0.1 Mg-0.1 Ca | 5 | 5 | 5 | 5 |
| 202 | Ag-1.7Cu-0.3Sm-0.1Ca | 4 | 5 | 5 | 4 |
| 203 | Ag-1.7Cu-0.3Er-0.1Mg | 5 | 5 | 5 | 5 |
| 204 | Ag-1.7Cu-0.3Dy | 5 | 5 | 5 | 5 |
| 205 | Ag-1.7Cu-0.4Pr | 5 | 5 | 5 | 5 |
| 206 | Ag-1.7Cu-0.4La | 5 | 5 | 5 | 5 |
| 207 | Ag-1.7Cu-0.3Y | 4 | 5 | 4 | 4 |
| 208 | Ag-1.7Cu-0.3Gd | 5 | 5 | 5 | 5 |
| 209 | Ag-1.7Cu-0.3Sm | 4 | 5 | 5 | 4 |
| 210 | Ag-1.7Cu-0.3Er | 5 | 5 | 5 | 5 |
| 211 | Ag-1.7Cu-0.3Dy-0.1Ga | 5 | 5 | 5 | 5 |
| 212 | Ag-1.7Cu-0.4Pr-0.1Ga | 5 | 5 | 5 | 5 |
| 213 | Ag-1.7Cu-0.4La-0.1Ga | 5 | 5 | 5 | 5 |
| 214 | Ag-1.7Cu-0.3Y-0.1Ga | 3 | 5 | 5 | 4 |
| 215 5 | Ag-1.7Cu-0.3Gd-0.1Ga | 5 | 5 | 5 | 5 |
| 216 | Ag-1.7Cu-0.3Sm-0.1Ga | 4 | 5 | 4 | 5 |
| 217 | Ag-1.7Cu-0.3Er-0.1Ga | 4 | 5 | 5 | 5 |
| 218 | Ag-1.7Cu-0.2Gd-0.2Er | 5 | 5 | 5 | 5 |
| 219 | Ag-1.7Cu-0.2Gd-0.2Pr | 5 | 5 | 5 | 5 |
| 220 | Ag-1.7Cu-0.2Er-0.2Pr | 5 | 5 | 5 | 5 |
| 221 | Ag-1.7Cu-0.2Gd-0.2Dy | 5 | 5 | 5 | 5 |
| 222 | Ag-1.7Cu-Gd-0.2Sm | 4 | 5 | 4 | 5 |
| 223 | Ag-1.7Cu-0.2Gd-0.2La | 5 | 5 | 5 | 5 |
| 224 | Ag-1.7Cu-0.2Gd-0.2Y | 5 | 5 | 5 | 4 |
| 225 | Ag-1.7Cu-0.2Er-0.2Dy | 5 | 5 | 5 | 5 |
| 226 | Ag-1.7Cu-0.2Er-0.2Sm | 4 | 5 | 5 | 4 |
| 227 | Ag-1.7Cu-0.2Er-0.2La | 5 | 5 | 5 | 5 |
| 228 | Ag-1.7Cu-0.2Er-0.2Y | 5 | 5 | 4 | 5 |
| 229 | Ag-1.7Cu-0.2Pr-0.2Dy | 5 | 5 | 5 | 5 |
| 230 | Ag-1.7Cu-0.2Pr-0.2Sm | 5 | 5 | 4 | 5 |
| 231 | Ag-1.7Cu-0.2Pr-0.2La | 5 | 5 | 5 | 5 |
| 232 | Ag-1.7Cu-0.2Pr-0.2Y | 5 | 5 | 4 | 5 |
| 233 | Ag-1.0Cu-0.2Gd-0.2Er-0.1Ga | 5 | 5 | 5 | 5 |
| 234 | Ag-1.0Cu-0.2Gd-0.2Pr-0.1Ga | 5 | 5 | 5 | 5 |
| 235 | Ag-1.0Cu-0.2Gd-0.2Er-0.2Pr-0.1Ga | 5 | 5 | 5 | 5 |
| 236 | Ag-1.0Cu-0.2Dy-0.1Ga | 5 | 5 | 5 | 5 |
| 237 | Ag-1.0Cu-0.2Gd-0.2Sm-0.1Ga | 5 | 5 | 5 | 4 |
| 238 | Ag-1.0Cu-0.2Gd-0.2La-0.1Ga | 5 | 5 | 5 | 5 |
| 239 | Ag-1.0Cu-0.2Gd-0.2Y-0.1Ga | 5 | 5 | 4 | 5 |
| 240 | Ag-1.0Cu-0.2Er-0.2Dy-0.1Ga | 5 | 5 | 5 | 5 |
| | Ag | 0 | 3 | 0 | 0 |

From these test results, the silver alloy thin films produced in the present embodiment all had superior durability to salt water and better adhesion than the pure silver thin film, thereby confirming that the films had high environmental resistance. This environmental resistance increases in conjunction with the increase in concentration of the added elements.

### B: Compositions Emphasizing Reflectance/Transmittance

Next, silver alloys having a composition which gave preference to transmittance and specific resistance were evaluated. In this evaluation as well, a thin film sample (thickness of 120 A) formed on a slide glass was placed on a hot plate, heated at 250°C for 1 hour, and its properties after heating were evaluated (heating test). A humidification test to examine the humidity resistance of the thin films was carried out by exposing the thin films to an atmosphere having a temperature of 100°C and a humidity of 100%, and evaluating the properties after humidification. The humidification test set an exposure time of 24 hours.

Further, the reflectance and transmittance after the corrosion tests were measured. Reflectance measurement was carried out using a spectrophotometer, wherein the reflectance of a pure silver thin film immediately after film formation was taken to be 100 so that the reflectance after film formation of the various silver alloy thin films could be evaluated as a relative value therewith. Transmittance measurement was carried out using the same spectrophotometer, wherein the transmittance of a substrate on which a thin film was not formed (borosilicate glass) was taken to be 100, and the transmittance of the various thin films was evaluated relatively therewith.

The evaluation results of reflectance and transmittance before and after the corrosion tests are shown in Tables 2 and 3. The respective measurement values are the values at wavelengths of 400 nm, 550 nm and 650 nm (corresponding to the wavelengths of blue, yellow and red in the visible light region). For comparison, the test results for a thin film from a target consisting of pure silver are also shown in the tables.

**[Table 2]**

| Reflectance | | | | | | | | | |
|---|---|---|---|---|---|---|---|---|---|
| Sample Composition | 400nm | | | 550nm | | | 650nm | | |
| | Immediately After Vapor Deposition | Heating Test | Humidification Test | Immediately After Vapor Deposition | Heating Test | Humidification Test | Immediately After Vapor Deposition | Heating Test | Humidification Test |
| Ag-1.7Cu | 83.2 | 77.1 | 78.0 | 93.9 | 90.4 | 97.6 | 96.6 | 95.0 | 98.8 |
| Ag-1.9Mn | 80.5 | 49.8 | 35.9 | 93.2 | 67.7 | 51.4 | 95.2 | 73.9 | 62.9 |
| Ag-3.7Si | 100.5 | 72.0 | 94.5 | 100.0 | 85.9 | 99.3 | 99.9 | 90.4 | 99.7 |
| Ag-1.8Ni | 95.0 | 86.5 | 94.1 | 98.5 | 93.6 | 98.7 | 98.8 | 94.6 | 99.1 |
| Ag-1.8Co | 93.5 | 81.4 | 92.9 | 98.2 | 92.0 | 98.6 | 98.7 | 93.9 | 99.3 |
| Ag-1.2Y | 100.7 | 45.4 | 98.6 | 100.4 | 61.3 | 100.5 | 100.3 | 67.8 | 100.5 |
| Ag-1.9Fe | 93.2 | 60.8 | 89.9 | 97.4 | 79.3 | 97.4 | 98.0 | 84.6 | 98.6 |
| Ag-2.4Sc | 100.1 | 88.6 | 41.6 | 100.5 | 95.6 | 73.8 | 100.6 | 97.5 | 81.9 |
| Ag-1.2Zr | 98.6 | 65.5 | 96.7 | 100.2 | 81.4 | 99.5 | 100.3 | 86.1 | 99.6 |
| Ag-1.2Nb | 88.8 | 92.4 | 93.2 | 98.8 | 99.1 | 99.5 | 99.3 | 99.7 | 100.0 |
| Ag-1.1Mo | 93.1 | 6.6 | 80.6 | 98.3 | 23.1 | 97.1 | 99.0 | 36.8 | 98.3 |
| Ag-0.6Ta | 89.1 | 86.5 | 88.4 | 98.9 | 97.4 | 97.2 | 99.5 | 98.8 | 98.1 |
| Ag-0.6W | 92.8 | 82.0 | 89.3 | 97.5 | 96.0 | 97.1 | 98.1 | 97.9 | 97.6 |
| Ag-1.1Ni-0.8Cr | 99.3 | 63.8 | 96.1 | 100.2 | 80.7 | 99.1 | 100.3 | 85.0 | 99.2 |
| Ag-0.8Cu-0.8Ga | 103.6 | 101.9 | 48.9 | 101.1 | 101.8 | 58.4 | 100.9 | 101.6 | 62.1 |
| Ag-1.7Cu-0.7Nd | 89.0 | 87.8 | 71.9 | 95.7 | 95.5 | 85.2 | 96.9 | 97.3 | 87.0 |
| Ag-0.8Cu-05In | 96.3 | 85.6 | 89.6 | 98.6 | 92.5 | 95.4 | 98.9 | 94.7 | 96.2 |
| Ag-0.5Cu-0.5Au | 99.8 | 68.6 | 73.6 | 100.3 | 87.8 | 85.7 | 100.3 | 82.8 | 85.9 |
| Ag-0.5Ni-0.5In | 93.2 | 83.6 | 88.4 | 97.2 | 92.3 | 94.8 | 97.8 | 93.6 | 95.2 |
| Ag-0.5Zr-0.5In | 97.9 | 63.3 | 86.8 | 99.2 | 75.7 | 91.4 | 97.9 | 63.3 | 86.8 |
| Ag-0.5Mo-0.5In | 93.6 | 69.8 | 88.6 | 98.9 | 78.4 | 97.5 | 93.6 | 69.8 | 88.6 |
| Ag | 100.0 | 30.5 | 45.9 | 100.0 | 52.5 | 78.4 | 100.0 | 60.5 | 86.0 |

**[Table 3]**

| Transmittance | | | | | | | | | |
|---|---|---|---|---|---|---|---|---|---|
| Sample Composition | 400nm | | | 550nm | | | 650nm | | |
| | Immediately After Vapor Deposition | Heating Test | Humidification Test | Immediately After Vapor Deposition | Heating Test | Humidification Test | Immediately After Vapor Deposition | Heating Test | Humidification Test |
| Ag-1.7Cu | 80.2 | 84.7 | 80.0 | 62.9 | 67.0 | 62.0 | 54.3 | 58.5 | 53.3 |
| Ag-1.9Mn | 76.8 | 85.2 | 74.9 | 61.9 | 69.8 | 59.7 | 53.4 | 61.3 | 50.7 |
| Ag-3.7Si | 80.4 | 70.3 | 74.5 | 64.7 | 54.4 | 58.8 | 55.1 | 44.8 | 48.8 |
| Ag-1.8Ni | 81.0 | 82.2 | 81.8 | 67.9 | 68.8 | 68.0 | 59.0 | 60.0 | 59.2 |
| Ag-1.8Co | 78.8 | 85.2 | 80.4 | 63.8 | 69.7 | 65.2 | 53.7 | 59.6 | 54.6 |
| Ag-1.2Y | 84.4 | 74.2 | 76.1 | 70.5 | 59.7 | 61.4 | 61.2 | 50.9 | 52.4 |
| Ag-1.9Fe | 81.2 | 71.4 | 74.9 | 67.1 | 57.0 | 60.9 | 57.1 | 47.0 | 49.9 |
| Ag-2.4Sc | 77.0 | 84.8 | 74.8 | 61.3 | 69.3 | 58.6 | 51.8 | 59.2 | 48.9 |
| Ag-1.2Zr | 75.2 | 84.2 | 75.8 | 61.2 | 70.8 | 62.0 | 53.2 | 62.0 | 53.1 |
| Ag-1.2Nb | 81.5 | 70.9 | 74.4 | 63.3 | 52.4 | 55.3 | 58.8 | 47.6 | 50.5 |
| Ag-1.1Mo | 80.8 | 77.7 | 74.6 | 64.8 | 62.2 | 58.7 | 55.6 | 52.1 | 48.7 |
| Ag-0.6Ta | 76.2 | 84.8 | 76.1 | 62.5 | 70.4 | 61.4 | 51.7 | 60.4 | 51.4 |
| Ag-0.6W | 75.6 | 85.5 | 76.7 | 62.1 | 71.0 | 61.8 | 52.6 | 62.2 | 53.1 |
| Ag-1.1Ni-0.8Cr | 76.3 | 85.5 | 75.7 | 61.6 | 69.6 | 59.4 | 51.2 | 60.0 | 50.0 |
| Ag-0.8Cu-0.8Ga | 81.5 | 81.2 | 80.6 | 67.3 | 65.8 | 65.5 | 58.7 | 57.3 | 56.3 |
| Ag-1.7Cu-0.7Nd | 85.0 | 75.1 | 76.7 | 68.5 | 57.4 | 58.6 | 59.0 | 48.9 | 50.2 |
| Ag-0.8Cu-05ln | 86.2 | 76.5 | 77.9 | 68.2 | 58.4 | 59.1 | 59.7 | 49.9 | 51.1 |
| Ag-0.5Cu-0.5Au | 84.9 | 74.7 | 76.4 | 71.9 | 61.3 | 62.5 | 63.7 | 52.5 | 53.2 |
| Ag-0.5Ni-0.5ln | 80.1 | 84.2 | 79.7 | 62.4 | 65.7 | 61.4 | 54.4 | 58.0 | 52.4 |
| Ag-0.5Zr-0.5ln | 74.5 | 78.0 | 74.3 | 59.7 | 62.6 | 59.2 | 51.7 | 54.1 | 50.0 |
| Ag-0.5Mo-0.5ln | 80.4 | 81.7 | 81.5 | 64.9 | 65.8 | 65.3 | 55.6 | 56.2 | 55.7 |
| Ag | 76.5 | 69.8 | 66.5 | 58.7 | 52.2 | 50.8 | 48.4 | 42.9 | 42.2 |

Reflectance immediately after film formation of the silver alloy according to the present invention exhibits a high reflectance of 95% or higher in the long wavelength region. The optimal composition can be selected by choosing the kind and added amount of added element. In the corrosion tests the pure silver thin film became clouded after just a few seconds in the heating test and lost its luster, and had only 30% reflectance. Further, in the humidification test as well, after 24 hours the pure silver thin film had lost some of its luster and had clouded over. On the other hand, it was confirmed by visual determination and by the actually recorded data for the respective wavelengths that the silver alloy thin films according to the present invention maintained a high reflectance without a loss of luster or clouding over even after the heating test and the humidification test.

Further, regarding transmittance evaluation as well, for the thin films comprising the silver alloy according to the present invention, it was confirmed from a comparison of the rate of change between immediately after film formation and after the corrosion tests that all of the alloys had a rate of change lower than that of pure silver, and that the silver alloys were superior to pure silver over each wavelength. In addition, generally, while transmittance increases in shorter wavelength regions, looking at the difference between transmittance at a short wavelength of 400 nm and transmittance at a long wavelength of 650 nm, pure silver had a large difference of 28%, while the silver alloys had a difference that was smaller than this. Thus, having a smaller difference in reduced transmittance due to the wavelength is a great advantage when trying to obtain white light as the transmitted light.

However, according to the present inventors, the phenomenon wherein localized agglomerates form on a humidified and heated thin film, whereby the underlying layer is exposed, is considered to be one factor in causing the reflectance of a reflective film consisting of silver to deteriorate from humidity and heat. Therefore, it can be said that if considering the qualities of reflectance maintenance properties, then it is preferable to examine for the presence of agglomerates during such humidification and heating.

Accordingly, in the present embodiment a test was conducted to examine for the occurrence of agglomerates from humidification and heating. In the test, first, a produced thin film was left to stand (for 20 to 30 minutes) in a cooling atmosphere set at a temperature equal to or lower than room temperature (preferably 10°C) to sufficiently cool the thin film along with the substrate. The cooled thin film was exposed to a humidifying environment or a heating environment. After the thin film had been taken out and dried, the surface appearance of the thin film was observed. The "humidifying environment" is an atmosphere having a temperature of 100°C and a humidity of 100%, and the exposure time in this case is preferably set at 20 minutes. The heating environment is an air atmosphere having a temperature of 250°C, and the exposure time in this case is preferably set at 60 minutes.

The surface appearance was observed after humidification and heating to evaluate the incidence level of silver agglomerates (hereinafter, these agglomerates are referred to as "black spots", due to the fact that they are formed as spots that are black in color) that form on the thin film surface after having humidification and heating. In this evaluation, it is preferable to set the size of the black spots to be counted at 1 to 10 µm. Clearly defining the evaluation subject in this way facilitates the evaluation.

Evaluation of the incidence level of black spots may be carried out, for example, by taking a photograph of the thin film surface and calculating the surface area ratio of the black spots by subjecting the photo to image processing. A simpler method is to evaluate by taking the surface condition (in this case, almost no black spots formed) of a silver thin film immediately after film formation as a reference, assessing the surface condition of the thin film after humidification and heating relative to the reference, and classifying into several levels.

In the present embodiment, the humidification environment was an atmosphere having a temperature of 100°C and a humidity of 100%, and the exposure time was set at 20 minutes. In a simulated evaluation of a thin film in the present embodiment, different types of 120 Å and 1,200 Å silver alloy thin films were produced. Each thin film was cooled and then exposed to the above described humidification environment. Then, the surface appearance of the thin films was observed with an optical microscopic (the 1,200 Å thin films were only subjected to the humidification test). The surface condition of the silver thin films immediately after the film formation was taken as a reference "level 1". The surface conditions were evaluated over a 5-point scale in worsening order (in order of descending number of black spots) of the surface condition from level 1 in such a way that the properties of the films were assessed through classification into levels 1 to 5. The results are shown in Table 4.

**[Table 4]**

| Film Thickness: 1200 Å | | |
|---|---|---|
| Level | Sample (at%) | |
| | Binary Alloy | Ternary Alloy |
| 1 | | |
| 2 | Ag-0.3Ni Ag-0.2Mo | Ag-1.0Ni-1.0Ga |
| 3 | | |
| 4 | Ag-1.7Cu Ag-1.0Co | |
| | Ag-1.0Ti Ag-1.0Sc | |
| | Ag-1.0Y Ag-1.0Mn | |
| 5 | Ag-0.1B Ag-0.25Si | Ag-0.8Cu-0.5In |
| | Ag-1.7Fe Ag-1.0Zr | |
| | Ag-1.0Nb Ah-0.5Ta | |
| | Ag-0.5W | |

| Film Thickness: 120 Å | | |
|---|---|---|
| Level | Sample (at%) | |
| | Binary Alloy | Ternary Alloy |
| 1 | | Ag-1.7Cu-2.0Ga |
| 2 | | |
| 3 | Ag-0.2Mo | |
| 4 | Ag-1.7Cu Ag-0.3Ni | Ag-0.2Mo-2.0Ga |
| 5 | | Ag-0.3Ni-2.0Ga |

From the results of this test, in terms of suppression of black spot incidence, preferred as the first added element group added to silver are nickel, molybdenum and copper, and preferred as the second added element group added thereto are indium and gallium.

In the present embodiment, a sulfidizing test was also carried out in order to evaluate reflectance maintaining properties under a sulfidizing atmosphere, and the reflectance after the test was evaluated. In the sulfidizing test, a thin film was dipped for 1 hour in 0.01% aqueous sulfide (temperature 25°C). The results are shown in Table 5. From these results, it was confirmed that the silver alloy thin films according to the present embodiment tend to have increased sulfidation resistance across all wavelengths.

**[Table 5]**

| Sample Composition (at%) | Reflectance | | | | | |
|---|---|---|---|---|---|---|
| | 400nm | | 550nm | | 650nm | |
| | Immediately After Vapor Deposition | After Test | Immediately After Vapor Deposition | After Test | Immediately After Vapor Deposition | After Test |
| Ag-1.70Cu | 83.2 | 62.4 | 93.9 | 73.5 | 96.6 | 78.6 |
| Ag-0.85Cu-0.5In | 96.3 | 51.0 | 98.6 | 66.1 | 98.9 | 75.7 |
| Ag-0.5Mo-0.5In | 93.6 | 51.2 | 98.9 | 65.1 | 99.2 | 73.7 |
| Ag-0.5Zr-0.5In | 97.9 | 37.7 | 99.2 | 50.2 | 99.3 | 62.5 |
| Ag-0.4Cu-0.5Au | 99.8 | 38.8 | 100.3 | 57.5 | 100.3 | 71.5 |
| Ag-1.7Cu-0.5Zn | 95.6 | 38.7 | 98.1 | 54.7 | 98.4 | 68.1 |
| Ag (comparison) | 100.0 | 31.3 | 100.0 | 39.6 | 100.0 | 53.5 |

Further, the samples that had undergone this sulfidizing test were subjected to a test to evaluate the adhesion of each thin film to the substrate. In this test, the same as in the above-described adhesion test, each thin film was crosscut to form a grid having a hundred of 1 mm squares. Then, cellophane tape was attached and stuck onto the grid, then peeled off in a single spell. The evaluation method was the same as that described above, an evaluation according to a 5 point scale. Table 4 shows the results of this adhesion test.

**[Table 6]**

| | Adhesion | | |
|---|---|---|---|
| Sample Composition | Immediately After Vapor Deposition | Heating Test | Humidification Test |
| Ag-1.7Cu | 5 | 5 | 5 |
| Ag-1.9Mn | 3 | 3 | 1 |
| Ag-3.7Si | 3 | 3 | 1 |
| Ag-1.8Ni | 5 | 5 | 5 |
| Ag-1.8Co | 5 | 5 | 5 |
| Ag-1.2Y | 5 | 5 | 3 |
| Ag-1.9Fe | 5 | 4 | 3 |
| Ag-2.4Sc | 4 | 4 | 3 |
| Ag-1.2Zr | 5 | 5 | 5 |
| Ag-1.2Nb | 5 | 5 | 5 |
| Ag-1.1 Mo | 5 | 5 | 5 |
| Ag-0.6Ta | 5 | 5 | 5 |
| Ag-0.6W | 5 | 5 | 5 |
| Ag-1.1Ni-0.8Cr | 4 | 4 | 3 |
| Ag-0.8Cu-08Ga | 5 | 5 | 5 |
| Ag-0.7Nd-1.7Cu | 5 | 4 | 4 |
| Ag-0.8Cu-0.5ln | 4 | 4 | 4 |
| Ag-0.5Ci-0.5Au | 5 | 5 | 4 |
| Ag-0.5Ni-0.5ln | 5 | 5 | 5 |
| Ag-0.5Zr-0.5ln | 5 | 5 | 5 |
| Ag-0.5Mo-0.5ln | 5 | 5 | 5 |
| Ag | 3 | 0 | 0 |

From these results, it can be seen that for a pure silver thin film, the thin film peels away from the entire surface of the substrate after the corrosion tests. In contrast, for the silver alloys according to the present invention, adhesion is greatly improved, whereby a strong adhesive force can be obtained in which there is absolutely no peeling immediately after film formation, and notably, no peeling even after undergoing the environmental tests. This is highly effective in enabling long-term use when thinking of using as a coating material.

### Industrial Applicability

The present invention is useful as a material used in a reflective film for various parts for which high reflectance is demanded. For parts used in liquid crystal panels, a uniform white light has to be reflected from the panel rear side. For instance, Ag, 0.8% Cu, 0.8% Ga, which is one example of the present invention, was formed to a 1,200 Å thickness on a 100 µm-thick PET film (30 cm × 30 cm). The reflectance immediately after film formation was 100% or higher, which is a high reflectance, and the deterioration after the environmental tests was also small. The adhesive force of the thin film to the PET film was sufficient, achieving a practical use level.

Further, for a high-intensity LED element or a laser element, while simultaneously improving the emission efficiency of the diodes, it is required to improve the reflection efficiency of the reflective material. Concerning this point, reflectance can be improved by about 10% by changing the reflective film material from the conventional aluminum to the silver alloy according to the present invention. For instance, high reflectance can be achieved if a Ag, 2.0% Cu, 2.0% Ga, 0.8% Gd silver alloy thin film is formed to a 1,200 Å thickness on the concave face of the lower portion of a light-emitting element. In addition, the present invention is also useful as a reflective film used in headlamps for automobiles or the like, or for general light fittings.

The present invention is useful in the field of solar cells. Among the various kinds of solar cell, thin film solar cells are usually composed of a unit formed from a transparent front electrode layer, plural layers of an amorphous silicon layer and a rear electrode layer on a transparent substrate. These "units" are connected in series-parallel for use as a power source. Light incident on the transparent substrate undergoes photoelectric conversion by the electricity-generating layer formed by the plural layers of amorphous silicon. In order to dramatically increase the generating efficiency at this point, the reflected light at the rear electrode also has to be re-used for electricity generation. To achieve this, a higher reflectance for each wavelength is required for the thin film forming the rear electrode. It is also necessary to have high-level environmental resistance capable of withstanding long-term use outside which can go on for several decades. Conventional rear electrodes have mostly used aluminum, which has meant that this point has not been sufficiently addressed. Further, while pure silver, which gives about a 10% improvement in reflectance over aluminum, has also been considered, pure silver could not sufficiently withstand the environmental tests which assumed an outside environment of several decades. According to the present invention, these problems are resolved, thereby enabling long-term practical use outside.

For instance, a transparent front electrode was fabricated by forming a 2,000 Å ITO thin film on a 30 cm × 30 cm 1.1 mm-thick transparent borosilicate glass substrate, then a 10 µm-thick amorphous silicon electricity-generating layer was formed, and a rear electrode consisting of Ag, 1.9% Cu, 2.5% Ga, 0.7% La as one example of the present invention was formed to a 1,200 Å thickness. A diffusion prevention layer and protection layer was formed as necessary between each of these layers. The thus-structured solar cell can generate electricity more efficiently due to the action of the rear electrode comprising a silver alloy, and also has long-term weatherability.

Further, in the field of solar cells, double-sided solar cells have recently been investigated, and the present invention is useful even for a solar cell having this form. In such a case, for example, as the transparent front electrode layer, the electrode can be fabricated by forming Ag, 0.8% Cu, 0.8% Ga as one example of the present invention to a thickness of 100 Å. In addition, application up to about 200 Å is possible while giving consideration to the balance with transmittance. Similarly, a double-sided solar cell can be obtained having a transparent rear electrode which is not totally reflective.

On the other hand, a transparent electrode can be formed even for electrode formation of a silicon single-crystal solar cell, by using the silver alloy thin film according to the present invention by itself, or by using together with an ITO thin film as a multilayer film or the like.

Further, the present invention is also useful as a reflective film for a building material having a light reflecting function. Glass and films which provide a sunlight reflecting function on window glass or the like are in demand in view of the recent energy saving measures and environmental protection measures. For instance, a semi-transmissive reflective film was produced by forming Ag, 2.0% Cu, 1.5% Ga, 1.3% Er to a 120 Å thickness on a 50 µm-thick PET film (50 cm × 50 cm).

Finally, the present invention is a useful silver alloy for accessories as well. Since silver turns black even if left inside, fastidious care has been necessary for accessories made from silver. If a silver alloy according to the present invention (e.g., Ag, 2.0% Cu, 2.0% Ga, 1.0% Pr) is used as a metal raw material used in an accessory, the accessory can be prevented from changing color and can be kept for a long time. The silver alloys according to the present invention can also be used as a spectacle frame. Although spectacle frames have a dual nature of being for practical use as well as a decoration, pure silver has not been practical because it turns black during use. With the silver alloys according to the present invention, a corrosion-resistant spectacle frame can be realized which keeps the same metallic luster and feel of pure silver, but unlike pure silver does not change color over a long time from body sweat or grease. Further, the present invention is also useful as a coating for accessories in order to provide a metallic reflection and feel to plastic wristwatch frames, automobile emblems and the like.

## Claims

1. A silver alloy having excellent reflectance and transmittance, comprising silver as a main component and as a first added element group at least one of nickel, molybdenum, copper, cobalt, titanium, scandium, yttrium, manganese, silicon, iron, zirconium, niobium, tantalum, tungsten, chromium and carbon.

2. The silver alloy according to claim 1, wherein the first added element group is copper, titanium, zirconium, manganese and yttrium.

3. The silver alloy according to claim 1 or 2, further comprising as a second added element group at least one of gallium, thulium, dysprosium, platinum, palladium, magnesium, zinc, terbium, gadolinium, erbium, gold, aluminum, neodymium, holmium, tin, bismuth, praseodymium, germanium, indium, samarium, ytterbium, strontium, boron, rhodium, iridium, ruthenium, zinc, antimony, hafnium, lanthanum, cerium, europium, calcium, lithium and phosphorus.

4. The silver alloy according to claim 3, wherein the second added element group is at least one of gallium, palladium, dysprosium, indium, tin, zinc, magnesium, aluminum, gadolinium, erbium, praseodymium, samarium and lanthanum.

5. The silver alloy according to any one of claims 1 to 4, wherein added element concentration total is 0.01 to 20.0 atom%.

6. The silver alloy according to claim 5, wherein the added element concentration total is 0.01 to 10.0 atom%.

7. A display device comprising a thin film which comprises the silver alloy according to any one of claims 1 to 6.

8. A building material comprising a thin film which comprises the silver alloy according to any one of claims 1 to 6 and a support which supports the thin film.

9. A liquid crystal panel comprising a thin film which comprises the silver alloy according to any one of claims 1 to 6.

10. An LED element comprising a thin film which comprises the silver alloy according to any one of claims 1 to 6.

11. A laser element comprising a thin film which comprises the silver alloy according to any one of claims 1 to 6.

12. A light fitting comprising a thin film which comprises the silver alloy according to any one of claims 1 to 6.

13. A solar cell comprising a thin film which comprises the silver alloy according to any one of claims 1 to 6.

14. Glass comprising a thin film which comprises the silver alloy according to any one of claims 1 to 6.

15. A film comprising a thin film which comprises the silver alloy according to any one of claims 1 to 6.

16. An accessory comprising the silver alloy according to any one of claims 1 to 6.

17. A target comprising the silver alloy according to any one of claims 1 to 6.
